# EUROPÄISCHE PATENTSCHRIFT

(11) **EP 0 377 078 B1**
(45) Veröffentlichungstag und Bekanntmachung des Hinweises auf die Patenterteilung: **06.04.1994**
(21) Anmeldenummer: 89112923.1
(22) Anmeldetag: 14.07.1989
(51) Int. Cl.: G01S 17/88, G01S 7/48, H01L 27/148

(54) **Bildsensor auf Halbleiterbasis, insbesondere in CCD-Struktur**
Semiconductor image sensor, in particular for a CCD structure
Capteur d'image à semi-conducteur, en particulier pour une structure CCD

(30) Priorität: 23.11.1988 DE 3839513
(43) Veröffentlichungstag der Anmeldung: 11.07.1990
(73) Patentinhaber: TEMIC TELEFUNKEN microelectronic GmbH, 74072 Heilbronn (DE)
(72) Erfinder: Spies, Hans, D-8068 Pfaffenhofen (DE); Wöhrl, Alfons, D-8898 Schrobenhausen (DE); Spies, Martin, D-8068 Pfaffenhofen 1 (DE)
(74) Vertreter: Maute, Hans-Jürgen, Dipl.-Ing.

(56) Entgegenhaltungen:
- EP-A- 0 269 902
- DE-A- 3 326 924
- DE-A- 3 829 003
- BILD DER WISSENSCHAFT, Oktober 1988, Seiten 134-135, Deutsche Verlags-Anstalt GmbH, Stuttgart, DE; "Prometheus - Steuermann durch den Verkehr von morgen"

## Beschreibung

Die Erfindung betrifft einen Bildsensor gemäß dem Oberbegriff des Anspruchs 1.

Halbleiterbildsensoren sind bekannt. Ihre Anwendung ist z.B. in einem Übersichtsaufsatz in der Zeitschrift Elektronik-Praxis Nr. 9 September 1978 Seite 12 ff. beschrieben.

Die Schwierigkeiten liegen in der Hochintegration und der anzuwendenden Technologie, die bewältigt werden muß.

Aufgabe vorliegender Erfindung ist es, einen Bildsensor zu schaffen, der unter Anwendung bekannter Halbleiterbauelemente und Technologien ein steuerbaren Sensor mit großem Nutzsignal ist und damit neue Anwendungen möglich werden.

Die Lösung dieser Aufgabe ist in Anspruch 1 enthalten. Damit wird ein elektrischer Verschluß für ein Photoelement geschaffen, dessen Nutzsignal gegenüber bekannten CCD-Anordnungen etwa 100-fach erhöht ist und bei dem der Verstärkungseffekt mit Hilfe einer steuerbaren Avalanche-Spannung einstellbar ist.

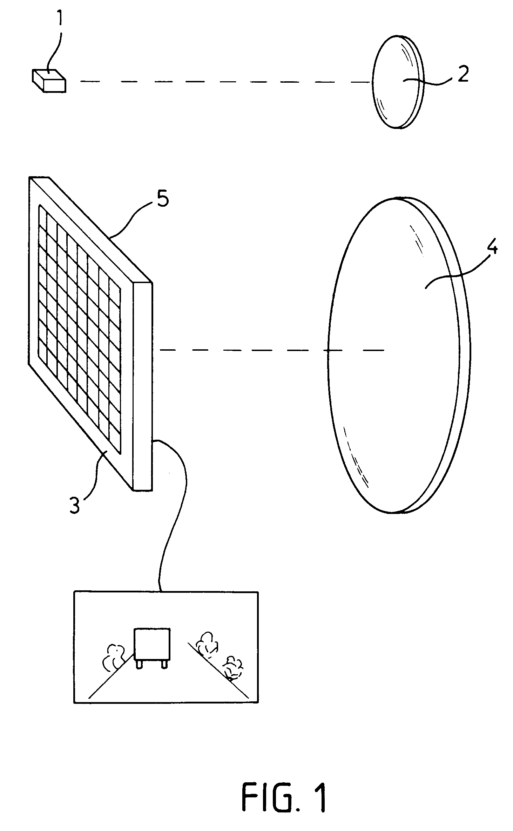

Ein besonderer Vorteil der Erfindung ist es, daß ein CCD-Sensor geschaffen wird, der auftastbar ist in der Größenordnung etwa 10 ns und darunter (zwischen 1 und 10 ns). Eine Gesamtanordnung bzw. der Aufbau des Gesamtsystems mit Sender und Empfänger ist in Fig. 1 ersichtlich. Die Erfindung gestattet die Anwendung eines Bildsensors für automatische Fahrzeugführung, -lenkung, -leitung oder mit besonderem Vorteil in KFZ-Laser-Abstandshaltesystemen, bei denen eine Laser-Entfernungsmessung zu dem Hindernis das stillsteht oder sich bewegt (Fahrzeug), angewandt wird. Eine Abbildung, wie sie mit dem neuen Bildsensor gewonnen wird, ist unter dem CCD-Array in Fig. 1 verkleinert dargestellt.

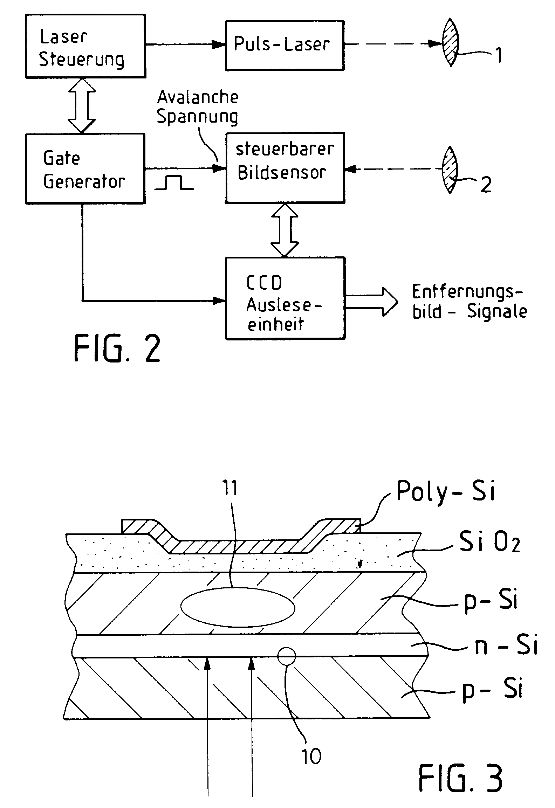

In Fig. 2 ist ein Blockschaltbild mit den Funktionsblöcken selbstredend dargestellt. Es ist ersichtlich eine Lasersteuerung für einen Pulslaser verbunden mit einem Gate-Generator, der eine Avalanche-Spannung abgibt an einen steuerbaren Bildsensor, letzterer dient als Empfänger mit einer Optik 2. Der Sender weist eine Optik 1 auf. Bildsensor und Generator sind mit einer CCD-Ausleseeinheit verbunden, welche Enfernungsbild-Signale generiert.

In Fig. 3 ist der Aufbau einer einzelnen fotoempfindlichen Zelle im Querschnitt dargestellt, wobei der Strahlungseinfall, z.B. Licht, in Fig. 3 von unten kommt. Im wesentlichen weist das Bildsensorelement auf Halbleiterbasis eine pnp-Struktur auf. Auf der Unterseite im Grenzgebiet zwischen dem p-Silizium und dem n-Silizium über dem dann wieder eine p-Siliziumschicht und darauf eine Siliziumdioxyd-Schicht folgt, ist eine Avalanche-Diode mit Verstärker 10 ausgebildet. Die elektrische Steuerung dieses Bildsensors erfolgt, indem eine Raumladung für den CCD-Transport erzeugt wird in einem Gebiet 11, das wie Fig. 3 zeigt, räumlich mit Vorteil etwa in einem zentralen Bereich des p-Siliziums über der hochohmiger n-Silizium-Schicht liegt. Über dem p-Silizium ist die transparente Schicht, z.B. Silizium-Dioxyd, angeordnet und in einer leichten Senke hierauf ebenso die CCD-Auslesestruktur z.B. Bereiche von Poly-Silizium oder ähnlich geeignetem Material, das in einer bekannten Technik für partielles Beschichten zum Herstellen einer Auslesestruktur hergestellt wurde. Das Auslesen und Auswerten ist an sich bekannt, daher nicht näher erläutert oder dargestellt (siehe DE 38 17 153 A1 oder "The Radio and Electronic Engineer" Vol. 50, No. 5, pp. 205, 206).

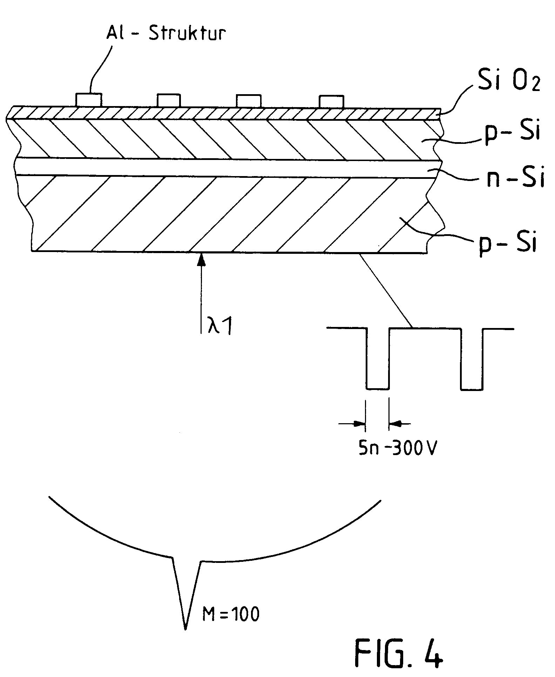

Eine Einzelheit aus dem Bildsensorelement ist in Fig. 4 dargestellt. Im oberen Teil dieser Fig. 4 ist wieder der wesentliche Schichtaufbau zu erkennen mit der p n p-Struktur mit hochohmiger n-Schicht im mittleren Bereich (sandwichartig). Auf der Oberseite in Fig. 4 ist eine dünne SiO₂-Schicht von Aluminium-Elektroden teilweise bedeckt für das Auslesen der CCD-Struktur. Der Lichteinfall der zu messenden Strahlung (mit einer Wellenlängen λ1) kommt in Fig. 4 von unten. Der Avalanche-Effekt, insbesondere Verstärkungseffekt bis zu 100-facher Verstärkung, ist symbolisch darunter dargestellt und das Anlegen einer negativen Steuerspannung, durch Auftasten im Bereich von etwa 5 ns, ebenfalls angedeutet in Fig. 4 Rechts unten, im Querschnitt neben der Schichtstruktur.

Das wesentliche am Aufbau des flächenhaften CCD-Sensors ist, daß an einer Seite des Halbleiters die flächenhafte CCD-Struktur und auf der entgegengesetzten Seite (Rückseite) des CCD-Sensors eine Avalanche-Diode ausgebildet ist, insbesondere durch Implantieren bzw. Dotieren mit an sich hierfür bekannten Dotierstoffen. Wird bei dem vorstehend beschriebenen Aufbau zwischen der hochohmigen n und der letzten p-Schicht eine hohe Spannung angelegt, dann entsteht bei Lichteinfall an der entsprechenden Stelle durch den Avalanche-Effekt eine hohe Feldstärke, die ihrerseits Ladungsträger in der p-Schicht unter der CCD-Struktur erzeugt (vgl. Fig. 3), welche mit Hilfe eines geeigneten Elektrodenaufbaus auslesbar sind. Da die Avalanchediode über die gesamte Fläche wirksam ist aber der Ladungstransport einzeln im Volumen des Halbleiters zu der CCD-Struktur hin erfolgt entsteht ein flächenhaftes Kontrast-Bild zum Zeitpunkt des Auftastens oder der Übertragung. Damit ist durch geeignete Wahl des Auftastzeitpunktes (Start) und der Auftastdauer (ns) und Korrelation der Auftastimpulse mit den Sendeimpulsen ein Entfernungsbild darstellbar.

Mit Erfindung wird u.a. ein elektrischer Verschluß für ein fotoempfindliches Element, wie Bildsensor insbesondere für eine CCD-Kamera geschaffen, der neben der großen Verstärkung oder Empfindlichkeitserhöhung etwa um den Faktor 100 steuerbar ist in sehr kurzen Zeiten einer Größenordnung, unter 10 ns Auftastzeit, die bisher jedenfalls bei vergleichbarem Aufwand nicht erzielbar ist.

Die Anwendung der Erfindung ist bei einem Abstandswarnsystem und Entfernungssystem mittels Laser nach DE 36 40 449 A1 von Vorteil.

Die Anwendung bei einem automatischen Führungssystem "Prometheus" vgl. Bild der Wissenschaft 10 - 1988, S. 134 ist besonders vorteilhaft.

## Patentansprüche

1. Bildsensor auf Halbleiterbasis, insbesondere in CCD-Struktur, mit einem zeilenförmigen oder flächenhaften (zweidimensionalen) Array und einer parallelen oder seriellen Auslesung **dadurch gekennzeichnet,** daß
- auf der einen Seite des Halbleiters, eine Avalanchediode angeordnet ist,
- durch die ein bei Lichteinfall von außen erzeugter Photostrom verstärkt wird,
- eine Raumladung im anschließenden Halbleitergebiet erzeugt wird und ein Ladungsträgertransport zur CCD-Struktur über eine steuerbare Elektrode erfolgt,
- in der auf der anderen Seite des Halbleiters angeordneten CCD-Auslesestruktur mit Auslese-Elektroden ein Kontrast- oder Entfernungsbild ausgegeben wird,
- daß die Verstärkung des Bildsensors durch Anlegen einer Spannung zwischen einer p-dotierten zwischen einer p-dotierten Schicht auf der Seite für den Lichteinfall und einer anschließenden hochohmigen n-dotierten Schicht elektrisch steuerbar ist.

2. Bildsensor nach Anspruch 1, **dadurch gekennzeichnet,** daß er zugleich als Verschluß angewendet wird.

3. Bildsensor nach einem der vorhergehenden Ansprüche, **dadurch gekennzeichnet,** daß er in einem KFZ-Abstandswarnsystem mit Laser-Sender und -Empfänger als Empfänger angewandt wird.

4. Bildsensor nach Anspruch 3, **dadurch gekennzeichnet,** daß er in automatischen Fahrzeugführungssystem mit gegenseitiger automatischer Abstandseinhaltung als Empfänger angewandt wird.

## Claims

1. A semiconductor-based image sensor, particularly with a CCD structure, with a linear or flat-surface (two-dimensional) array and parallel or serial read-out, characterised in that
- an avalanche diode is disposed on one side of the semiconductor,
- by means of which avalanche diode a photocurrent produced by the incidence of light from the outside is amplified,
- a space charge is produced in the adjoining semiconductor region and charge carrier transport takes place to the CCD structure via a controllable electrode,
- a contrast or distance image is produced as an output in the CCD read-out structure with read-out electrodes disposed on the other side of the semiconductor,
- and that the amplification of the image sensor can be electrically controlled by applying a voltage between a p-doped layer on the side of the incident light and an adjoining high-impedance n-doped layer.

2. An image sensor according to claim 1, characterised in that it is employed simultaneously as a shutter.

3. An image sensor according to any one of the preceding claims, characterised in that it is employed as a receiver in a motor vehicle distance warning system with a laser transmitter and receiver.

4. An image sensor according to claim 3, characterised in that it is employed as a receiver in an automatic vehicle guidance system with automatic mutual distance maintenance.

## Revendications

1. Détecteur d'image à base de semi-conducteur, en particulier en structure CCD, comprenant un réseau linéaire ou plat (bidimensionnel) et une lecture parallèle ou sérielle, caractérisé par le fait que :
- sur l'un des côtés du semi-conducteur est disposé une diode à avalanche,
par laquelle un courant photo-électrique produit en cas d'incidence de lumière de l'extérieur est amplifié,
- une charge d'espace est produite dans la zone suivante du semi-conducteur et un transport de porteurs de charge vers la structure CCD s'effectue par une électrode commandée,
- une image de contraste ou de distance est produite dans la structure de lecture CCD avec électrodes de lecture, disposée sur l'autre côté du semi-conducteur,
- l'amplification du détecteur d'image peut être commandée électriquement par application d'une tension entre une couche dopée p sur le côté d'incidence de lumière et une couche suivante dopée n, à résistance ohmique élevée.

2. Détecteur d'image suivant la revendication 1, caractérisé par le fait qu'il est utilisé comme obturateur.

3. Détecteur d'image suivant l'une des revendications précédentes, caractérisé par le fait qu'il est utilisé comme émetteur dans un système avertisseur de distance pour véhicules automobiles, avec émetteur et récepteur laser.

4. Détecteur d'image suivant la revendication 3, caractérisé par le fait qu'il est utilisé comme récepteur dans un système automatique de guidage de véhicule avec maintien automatique de distance réciproque.
